(19) Europäisches Patentamt / European Patent Office / Office européen des brevets

(11) **EP 2 471 115 B1**

(12) **EUROPÄISCHE PATENTSCHRIFT**

(45) Veröffentlichungstag und Bekanntmachung des Hinweises auf die Patenterteilung:
**01.04.2015 Patentblatt 2015/14**

(21) Anmeldenummer: **10757739.7**

(22) Anmeldetag: **24.08.2010**

(51) Int Cl.:
*H01L 39/14* *(2006.01)*   *H01L 39/24* *(2006.01)*

(86) Internationale Anmeldenummer:
**PCT/EP2010/062285**

(87) Internationale Veröffentlichungsnummer:
**WO 2011/023670 (03.03.2011 Gazette 2011/09)**

(54) **MULTIFILAMENTLEITER UND VERFAHREN ZU DESSEN HERSTELLUNG**

MULTIFILAMENT CONDUCTOR AND METHOD FOR PRODUCING SAME

CONDUCTEUR MULTIFILAMENTAIRE ET SON PROCÉDÉ DE PRODUCTION

(84) Benannte Vertragsstaaten:
**AL AT BE BG CH CY CZ DE DK EE ES FI FR GB GR HR HU IE IS IT LI LT LU LV MC MK MT NL NO PL PT RO SE SI SK SM TR**

(30) Priorität: **26.08.2009 DE 102009038920**

(43) Veröffentlichungstag der Anmeldung:
**04.07.2012 Patentblatt 2012/27**

(73) Patentinhaber: **Siemens Aktiengesellschaft 80333 München (DE)**

(72) Erfinder:
• **RIES, Günter**
**91056 Erlangen (DE)**
• **NEUMÜLLER, Heinz-Werner**
**91080 Uttenreuth (DE)**

(56) Entgegenhaltungen:
**WO-A2-01/08169   US-A1- 2006 040 830 US-B1- 7 756 557**

• **BARNES P N ET AL: "Low AC Loss Structures in YBCO Coated Conductors With Filamentary Current Sharing", IEEE TRANSACTIONS ON APPLIED SUPERCONDUCTIVITY, IEEE SERVICE CENTER, LOS ALAMITOS, CA, US, Bd. 15, Nr. 2, 1. Juni 2005 (2005-06-01), Seiten 2827-2830, XP011134270, ISSN: 1051-8223, DOI: DOI: 10.1109/TASC.2005.848236**

EP 2 471 115 B1

**Beschreibung**

Die vorliegende Erfindung bezieht sich auf einen Multifilamentleiter mit einem bandförmigen Substrat und mit wenigstens einer supraleitenden Schicht. Die wenigstens eine supraleitende Schicht ist auf wenigstens einer Oberfläche des bandförmigen Substrats ausgebildet und in Filamente unterteilt. Das bandförmige Substrat weist parallel zu seiner Längsausdehnung eine erste Richtung auf und das wenigstens ein Filament weist parallel zu seiner Längsausdehnung eine zweite Richtung auf. Weiterhin bezieht sich die Erfindung auf ein Verfahren zur Herstellung eines solchen Multifilamentleiters.

Multifilamentleiter mit supraleitenden Schichten werden unter anderem als Leiter in supraleitenden Einrichtungen verwendet. So können sie z.B. in supraleitenden Wicklungen von Magnetspin-Tomographen, in Motoren, in Generatoren oder in Strombegrenzern eingesetzt werden. Insbesondere bei der Verwendung von Hochtemperatur-Supraleitenden (HTS)-Materialien, wie z.B. $Y_2BaCu_3O_7$ (YBCO), werden schon bei Temperaturen des flüssigen Stickstoffs supraleitende Eigenschaften der Leiter erreicht. Zuverlässige und kostengünstige supraleitende Einrichtungen lassen sich so realisieren.

Technische HTS-Leiter der zweiten Generation (2G) weisen als stromtragende Schicht einen einkristallinen HTS-Dünnfilm, insbesondere aus keramischen YBCO auf, der auf einem metallischen bandförmigen Träger ausgebildet ist. Zum Aufbringen des einkristallinen HTS-Dünnfilms auf den Träger ist dieser mit einer texturierten mehrschichtigen Pufferschicht beschichtet, auf welche die HTS-Schicht durch Abscheidungsverfahren wie z.B. Verdampfen, Laserdeposition oder chemische Zersetzung aufgebracht wird.

Auf die HTS-Schicht wird zusätzlich eine normalleitende Schutz- bzw. Stabilisierungsschicht aufgebracht, welche Fehlstellen und normalleitend gewordene kurze Abschnitte in der HTS-Schicht elektrisch überbrücken kann und die HTS-Schicht vor mechanischer Beschädigung schützt. Die normalleitende Schicht besteht in der Regel aus Silber und/oder Kupfer. Der bandförmige Träger, auf welchem der Schichtstapel aus Puffer-, HTS- und Stabilisierungsschicht aufgebracht ist, weist in der Regel eine Breite im Bereich von Millimetern oder Zentimetern auf.

In Wechselstromanwendungen tritt häufig eine zeitlich veränderliche Feldkomponente senkrecht zum bandförmigen Träger auf. Dadurch werden in der HTS-Schicht, und in geringerem Maße auch in der Stabilisierungsschicht, zirkulierende Abschirm-Ströme induziert, welche sich einem Transportstrom überlagern. Diese Abschirm-Ströme führen zu elektrischen Verlusten, welche in Form von Wärme freigesetzt werden, und von einer Kühleinrichtung von den HTS-Leitern abgeführt werden müssen. Wirtschaftliche Vorteile durch Energieeinsparung, welche durch den Einsatz von HTS-Leitern gegenüber klassischen ohmschen Leitern erzielt werden, werden dadurch verringert oder vollständig aufgehoben.

Verluste pro Länge $P_h/L$ sind proportional zur Wechselfeldamplitude $\Delta B$, Frequenz f, kritischem Strom $I_C$ und effektiver Leiterbreite $d_f$ senkrecht zum Magnetfeld:

$$P_h/L = f \times \Delta B \times I_C \times d_f$$

In NbTi- und $Nb_3Sn$-Supraleitern werden die Verluste verringert, indem der Querschnitt auf viele dünne Filamente mit kleinem $d_f$ aufgeteilt wird, die in einer Metallmatrix, z.B. Kupfer, eingebettet sind. Wirksam ist diese Maßnahme aber nur, wenn der Leiter verdrillt bzw. verseilt wird.

Eine Übertragung dieses Prinzips auf HTS-Leiter ist durch Roebel-Leiter gegeben. Aus der WO 03/100875 A2 ist ein solcher Roebel-Leiter bekannt, welcher aus mehreren parallelen HTS-beschichteten bandförmigen Trägern aufgebaut ist. Verluste werden in einem entsprechenden Aufbau eines HTS-Leiters durch die Breite des Einzelbandes bestimmt. Um Verluste weiter zu minimieren ist z.B. aus der US 2007/0191202 A1 bekannt, die supraleitende Schicht und die Stabilisierungsschicht aus Kupfer durch Längsrillen parallel der Längsrichtung des bandförmigen Trägers in Filamente zu unterteilen. Methoden zur Ausbildung der bis auf den Träger reichenden Längsrillen bzw. Gräben umfassen mechanische Behandlung, chemisches Ätzen, Laserbearbeitung, Photoresisttechniken und lokales zerstören kristalliner Ordnungen. Dadurch wird ein Filament auf einem Träger in viele einzelne Filamente unterteilt, welche parallel der Längsachse des Trägers verlaufen. Als effektive Leiterbreite $d_f$ wird die Breite der Einzelfilamente auf dem Träger erhalten, im Gegensatz zur Breite des supraleitend beschichteten Trägers als Filament.

In kurzen Leiterproben kann zwar eine Reduzierung der Verluste nachgewiesen werden, in langen Leiterstücken, z.B. in Spulenwicklungen, ist aber die magnetische Kopplung zwischen Filamenten nicht aufgehoben und ein externes Wechselfeld, wie es z.B. in Spulen besteht, induziert weiterhin große Abschirmströme. Die Abschirmströme können die kritische Stromdichte des supraleitenden Materials übersteigen, wodurch der Supraleiter in den resistiven Bereich übergeht. Es entstehen erhebliche elektrische Verluste, welche wiederum in Form von Wärme abgeführt werden müssen.

In weiteren bekannten supraleitenden Multifilamentleitern sind Filamentabschnitte in einem von Null verschiedenen Wickel zur Längsrichtung des Substrats angeordnet. In solchen Multifilamentleitern sind die induktiven Wechselstromverluste weiter reduziert. Entsprechende Multifilamentleiter sind in den "IEEE Transactions on Applied Superconductivity", Vol. 15, 2005, Seiten 2827 bis 2830 sowie in der US 2006/0040830 A1 und der WO 01/008169 offenbart. In diesen Multifilamentleitern liegt der Winkel zwischen den Filamenten und der Längsrichtung des Substrats in einem Bereich zwischen 30 und 60 Grad, meist bei etwa 45 Grad, so dass auf einer relativ geringen Längsausdehnung eine Überkreuzung der Filamente erreicht werden kann.

Aufgabe der vorliegenden Erfindung ist es, einen Multifilamentleiter anzugeben, welcher im Vergleich zu bekannten Multifilamentleitern aus dem Stand der Technik, eine weitere Verringerung der elektrischen Verluste aufweist. Insbesondere ist es Aufgabe eines erfindungsgemäßen Multifilamentleiters, die Induktion von Strömen im Multifilamentleiter in äußeren Wechselfeldern zu minimieren. Weitere Aufgabe der vorliegenden Erfindung ist es, ein Verfahren zur Herstellung eines Multifilamentleiters anzugeben, welcher minimale elektrische Verluste bei minimierter Induktion von Strömen im Multifilamentleiter in äußeren Wechselfeldern aufweist.

Die angegebene Aufgabe wird bezüglich des Multifilamentleiters mit den Merkmalen des Anspruchs 1 und bezüglich des Verfahrens zur Herstellung des Multifilamentleiters mit den Merkmalen des Anspruchs 11 gelöst.

Vorteilhafte Ausgestaltungen des erfindungsgemäßen Multifilamentleiters und des Verfahrens zur Herstellung des Multifilamentleiters gehen aus den jeweils zugeordneten abhängigen Unteransprüchen hervor. Dabei können die Merkmale der nebengeordneten Ansprüche mit Merkmalen eines jeweils zugeordneten Unteranspruchs oder vorzugsweise auch mit Merkmalen mehrerer zugeordneter Unteransprüche kombiniert werden.

Der erfindungsgemäße Multifilamentleiter weist ein bandförmiges Substrat und wenigstens eine supraleitende Schicht auf. Die wenigstens eine supraleitende Schicht ist auf wenigstens einer Oberfläche des bandförmigen Substrats ausgebildet und in Filamente unterteilt. Das bandförmige Substrat weist parallel zu seiner Längsausdehnung eine erste Richtung auf und das wenigstens eine Filament weist parallel zu seiner Längsausdehnung eine zweite Richtung auf. Die erste Richtung des bandförmigen Substrats schließt mit der zweiten Richtung des wenigstens einen Filaments einen Winkel ein, welcher zwischen 1 und 5 Grad liegt.

Dadurch können die Verluste in Wechselfeldanwendungen und die Einflüsse von lokalen Schadstellen in technischen supraleitenden Leitern, bei Verwendung der Multifilamentleiter in z.B. Spulen, bei welchen die Leiter übereinander gewickelt sind, wirksam reduziert werden. Insbesondere in bifilar gewickelten Spulen erfolgt eine erhebliche Verringerung von Verlusten. Die Verluste $P_h$ durch eine zum Multifilamentleiter senkrechte Wechselfeldamplitude $\Delta B$ sind nicht von der Leiterbreite sondern von der Breite der Einzelfilamente abhängig. Der Anteil von Hystereseverlusten verringert sich um den Faktor $d_f/b$. In Magnetanwendungen, z.B. in der Kernspintomographie, in Kernresonanzspektrometern und in Beschleunigern, bei denen eine hohe Feldgenauigkeit gefordert wird, werden durch die kleineren und auf die Filamentbreite lokalisierten Abschirmungsströme erzeugten Feldfehler im Nutzvolumen erheblich reduziert.

Besonders vorteilhaft ist ein Winkel zwischen der ersten Richtung des bandförmigen Substrats und der zweiten Richtung des wenigstens einen Filaments zwischen 1 und 5 Grad. Das wenigstens eine Filament kann vollständig entlang der zweiten Richtung ausgebildet sein, insbesondere ohne eine Längskomponente parallel der ersten Richtung. Längskomponenten entlang der ersten Richtung erhöhen in Anwendungen, wie z.B. bifilar gewickelten Spulen, die Verluste.

Das bandförmige Substrat kann eine erste Oberfläche auf einer Vorderseite und eine gegenüberliegende zweite Oberfläche auf einer Rückseite aufweisen, wobei sowohl auf der ersten als auch auf der zweiten Oberfläche mehrere Filamente ausgebildet sind. Die Filamente der ersten Oberfläche können eine zweite Richtung aufweisen, welche ungleich einer dritten Richtung parallel der Längsrichtung der Filamente der zweiten Oberfläche ist. Ein Effekt der Verlustreduzierung analog der Reduzierung in bifilar gewickelten Spulen wird dadurch in dem Leiter erreicht.

Dabei ergibt sich insbesondere bei transponierter Ausführung des Leiters eine verlustarme Stromleitung. Dazu kann das wenigstens eine Filament der Vorderseite mit dem wenigstens einem Filament der Rückseite elektrisch leitend verbunden sein, insbesondere über wenigstens eine Schicht, welche auf wenigstens einer dritten Oberfläche auf einer oder zwei Seitenflächen des bandförmigen Substrats ausgebildet ist. Eine Transpositionslänge kann im Bereich von 20cm liegen.

Eine Überbrückung von Fehlstellen in der supraleitenden Schicht kann besonders effektiv erfolgen, und Verluste damit weiter reduziert werden, wenn zwischen wenigstens zwei benachbarten Filamenten auf einer Oberfläche wenigstens eine elektrische Brücke ausgebildet ist. Durch die Brücke bzw. durch die Brücken ist eine elektrische Verbindung bzw. sind elektrische Verbindungen der wenigstens zwei benachbarten Filamente gebildet. Die wenigstens eine elektrische Brücke kann mittig auf der einen Oberfläche angeordnet sein, insbesondere mit einer Längsrichtung der Brücke parallel der einen ersten Richtung des bandförmigen Substrats. Ein fehlerhaftes Filament mit verringerter lokaler Stromtragfähigkeit wird über die Brücke und das benachbarte Filament elektrisch überbrückt.

Der Multifilamentleiter kann einen Schichtstapel aus bandförmigen Trägermaterial, wenigstens einer Pufferschicht, wenigstens einer supraleitenden Schicht, insbesondere einer Hochtemperatur-Supraleitenden (HTS)-Schicht, und/oder wenigstens einer Stabilisierungsschicht aufweisen. Die Pufferschicht ermöglicht eine epitaktisch aufgewachsene einkristalline supraleitende Schicht auf dem Trägermaterial. Eine HTS-Schicht ermöglicht den Einsatz des Multifilamentleiters mit supraleitenden Eigenschaften auch bei Temperaturen im Bereich des flüssigen Stickstoffs. Die Stabilisierungsschicht schützt die supraleitende Schicht vor mechanischen Beschädigungen und überbrückt elektrisch lokale Stellen in der supraleitenden Schicht mit verringerter Stromtragfähigkeit, d.h. sie stabilisiert und schützt mechanisch und elektrisch.

Das Trägermaterial kann aus einem Metall, insbesondere Stahl bestehen. Die wenigstens eine Pufferschicht kann wenigstens ein Material aus der Gruppe Al, Yttria, IBAD MgO, Homo-epi MgO, LMO umfassen oder Kombinationen bzw. Legierungen aus diesen Materialien oder Schichtstapel aus diesen Materialien. Die wenigstens eine supraleitende Schicht kann aus YBCO bestehen. Die wenigstens eine Brücke kann ebenfalls aus YBCO bestehen, insbesondere aus YBCO der wenigstens einen HTS-Schicht. Dies ermöglicht eine verlustfreie elektrische Leitung auch über die Brücke. Die wenigstens eine Stabilisierungsschicht kann aus Kupfer oder Silber bestehen oder einen Schichtstapel mit wenigstens einer Kupfer- und/oder wenigstens einer Silbeschicht umfassen. Die wenigstens eine Brücke kann auch aus dem Material der wenigstens einen Stabilisierungsschicht bestehen oder dieses umfassen, was eine einfache Herstellung der Brücke erlaubt.

Das Trägermaterial kann eine Dicke im Bereich von 50 bis 100$\mu$m und eine Breite im Bereich von 10mm aufweisen. Die wenigstens eine Pufferschicht kann eine Dicke im Bereich von 100nm aufweisen. Die wenigstens eine supraleitende Schicht kann eine Dicke im Bereich von 1$\mu$m aufweisen und das wenigstens eine Filament kann eine Breite im Bereich von 0.5mm aufweisen. Die wenigstens eine Stabilisierungsschicht kann eine Dicke im Bereich von 3$\mu$m bis 300$\mu$m aufweisen. Dies sind günstige Maße für eine Vielzahl von Anwendungen eines Multifilamentleiters.

Ein erfindungsgemäßes Verfahren zur Herstellung des zuvor beschriebenen Multifilamentleiters umfasst die Schritte,

- dass zwei bandförmige Trägermaterialien mit sich gegenüberliegenden Seiten in mechanischer Verbindung miteinander gebracht werden, und
- jeweils auf einer Seite eines bandförmigen Trägermaterials, welche der Seite der mechanischen Verbindung gegenüber liegt, wird wenigstens eine supraleitende Schicht aufgebracht, und
- auf die supraleitende Schicht wird eine Stabilisierungsschicht aufgebracht,
- wobei die Stabilisierungsschicht eines ersten bandförmigen Trägermaterials mit der Stabilisierungsschicht eines zweiten bandförmigen Trägermaterials an den Rändern der zwei bandförmigen Trägermaterialien überlappend ausgebildet werden, so dass eine elektrische Verbindung der Stabilisierungsschichten über die Ränder erfolgt, und
- die supraleitenden Schichten und die Stabilisierungsschichten werden in Filamente unterteilt.

Die zwei bandförmigen Trägermaterialien können deckungsgleich in Verbindung miteinander gebracht werden. Durch dieses Verfahren wird eine einfache, kostengünstige Herstellung des Multifilamentleiters mit wenigen Schritten ermöglicht.

Das Aufbringen von Schichten kann durch Elektrolyse, Auflöten, Aufdampfen, Sputtern, und/oder thermische Zersetzung von Metallverbindungen in der Dampfphase erfolgen. Die Unterteilung der supraleitenden Schichten und die Unterteilung der Stabilisierungsschichten in Filamente können mechanisch oder durch Lasern und/oder Ätzen, insbesondere trocken oder nasschemisches Ätzen, von durch eine Schicht jeweils durchgehenden Gräben erfolgen. Photolithographie kann insbesondere bei Ätzverfahren verwendet werden. Das Aufbringen von Schichten kann alternativ durch Bedrucken oder Bekleben des noch unbeschichteten Substratbands an der Position der Gräben erfolgen. Bei der folgenden Abscheidung von Supraleiter- und Stabilisierungsschichten erfolgt hier kein Materialauftrag, so dass die gewünschte Filamentstruktur ausgebildet wird.

Gräben können in einem Winkel zwischen der ersten Richtung des bandförmigen Substrats und der zweiten Richtung des wenigstens einen Filaments zwischen 1 und 5 Grad ausgebildet werden. Die Filamente können auf den zwei bandförmigen Trägermaterialien über deren Ränder elektrisch derart verbunden werden, dass spiralförmige Strompfade entstehen.

Die zwei bandförmigen Trägermaterialien des doppelschichtigen Substrats können durch eine hitzebeständige, isolierende Zwischenlage oder einen Luftspalt voneinander getrennt werden. Dies kann insbesondere durch verschweißen von zwei bandförmigen Trägermaterialien, durch Biegen eines bandförmigen Trägerbandes in zwei übereinanderliegende Bänder, oder durch Flachwalzen eines Rohres, insbesondere vor einem Schritt des texturierenden Walzens der bandförmigen Trägermaterialien, erfolgen.

Für das erfindungsgemäße Verfahren zur Herstellung des Multifilamentleiters ergeben sich die vorstehend erwähnten, mit dem erfindungsgemäßen Multifilamentleiter verbundenen Vorteile.

Bevorzugte Ausführungsformen der Erfindung mit vorteilhaften Weiterbildungen gemäß den Merkmalen der abhängigen Ansprüche werden nachfolgend anhand der folgenden Figuren näher erläutert, ohne jedoch darauf beschränkt zu sein.

Es zeigen:

Fig. 1    einen Multifilamentleiter in Schrägansicht mit Filamenten parallel der Substratachse nach dem Stand der Technik, und

Fig. 2    den Schichtaufbau eines Filaments eines Multifilamentleiters nach dem Stand der Technik, und

Fig. 3    einen erfindungsgemäßen Multifilamentleiter mit Filamenten, welche schräg auf einer Vorder- und Rückseite eines Substrats, spiralförmig um dessen Umfang verlaufend ausgebildet sind, und

Fig. 4    einen Multifilamentleiter analog dem in Fig. 3 gezeigten, wobei Brücken zwischen benachbarten Filamenten ausgebildet sind, und

Fig. 5    eine Aufsicht auf den in Fig. 3 gezeigten Multifilamentleiter mit Filamenten auf der Vorder- (begrenzt von durchgehenden Linien) und Rückseite (gestrichelte Linien), und

Fig. 6a    eine Schnittansicht des in Fig. 3 gezeigten Multifilamentleiters mit zwei in direkter Verbindung stehenden Trägern, und

Fig. 6b    eine Schnittansicht des in Fig. 3 gezeigten Multifilamentleiters mit einem zusammengedrückten Rohr als Substrat, und

Fig. 6c    eine Schnittansicht des in Fig. 3 gezeigten Multifilamentleiters, welcher aus einem zusammengeklappten Teil als Substrat mit einer Schweißnaht an der offenen Seite besteht.

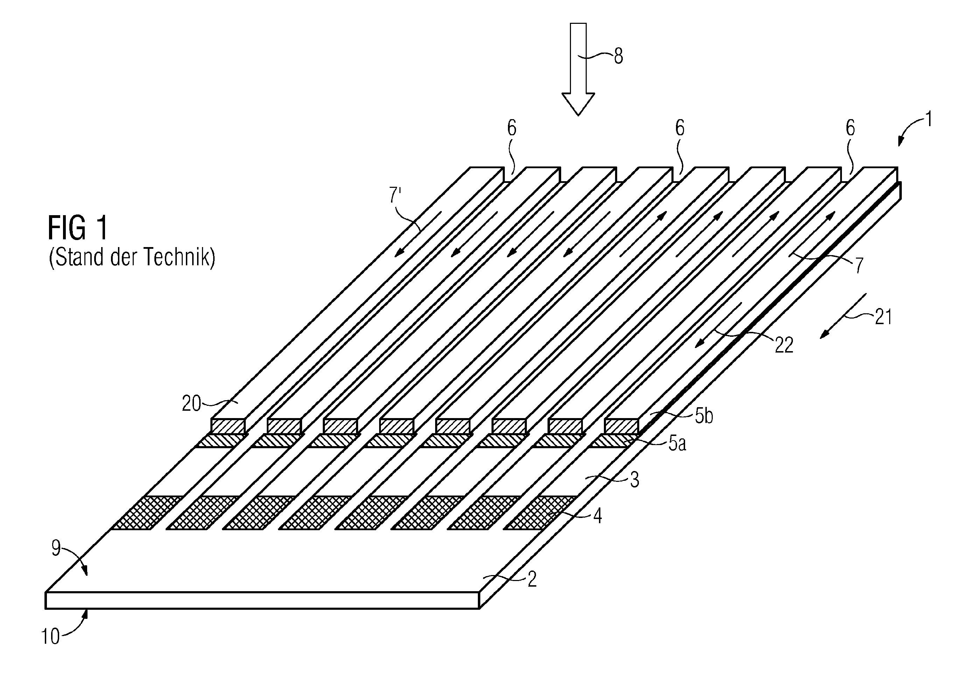

Fig. 1 zeigt einen Schnitt senkrecht der Längsachse eines Multifilamentleiters 1, in Schrägansicht von Vorne auf den Multifilamentleiter 1, nach dem Stand der Technik. Der Multifilamentleiter 1 weist ein bandförmiges Substrat 2, mit einer Vorderseite 9 und einer Rückseite 10 auf. Eine erste Richtung 21 des bandförmigen Substrats 2 ist definiert als die Längsrichtung des bandförmigen Substrats 2. Parallel zu der ersten Richtung 21 sind auf der Vorderseite 21 des bandförmigen Substrats 2 streifenförmig, parallel zu einander Streifen einer Pufferschicht 4 aufgebracht. Die Streifen der Pufferschicht 4 sind voneinander beabstandet und weisen eine zweite Richtung 22 auf, welche der Längsrichtung der Streifen der Pufferschicht 4 entspricht. Auf den Streifen der Pufferschicht 4 ist eine supraleitende Schicht 3, z.B. aus YBCO-Material ausgebildet. Auf der supraleitenden Schicht 3 ist eine dünne Silberschicht (Ag-Schicht) 5a und eine Kupferschicht (Cu-Schicht) 5b als Stütz- bzw. Stabilisierungsschicht 5 ausgebildet. Zwischen den Schichtstapeln bzw. Filamenten 20, jeweils bestehend aus der Pufferschicht 4, der supraleitenden Schicht 3, und der Stabilisierungsschicht 5, sind durchgehende Gräben 6 zur Beabstandung der Filamente 20 ausgebildet.

Bei einem Einwirken eines äußeren zeitveränderlichen Magnetfelds (B) 8 auf den Multifilamentleiter 1 werden Ströme I in der Stabilisierungsschicht 5 und/oder der supraleitenden Schicht 3 induziert. Diese induzierten Ströme I fließen in einer Hälfte der Anzahl an Filamenten 20 mit einer Stromrichtung 7 und in der anderen Hälfte der Anzahl an Filamenten 20 mit einer entgegengesetzt gerichteten Stromrichtung 7'. An den Leiterenden schließen sich die Strompfade. Die Ströme I übersteigen im Allgemeinen den kritischen Strom der Filamente 20 und treiben den Supraleiter in den resistiven Zustand, wobei erhebliche ohmsche Verluste entstehen. Diese steigen in einem unverdrillten Leiter nach Fig. 1 linear mit der ganzen Bandbreite b, die Unterteilung in Filamente 20 der Breite $d_f$ entfaltet keine Wirkung.

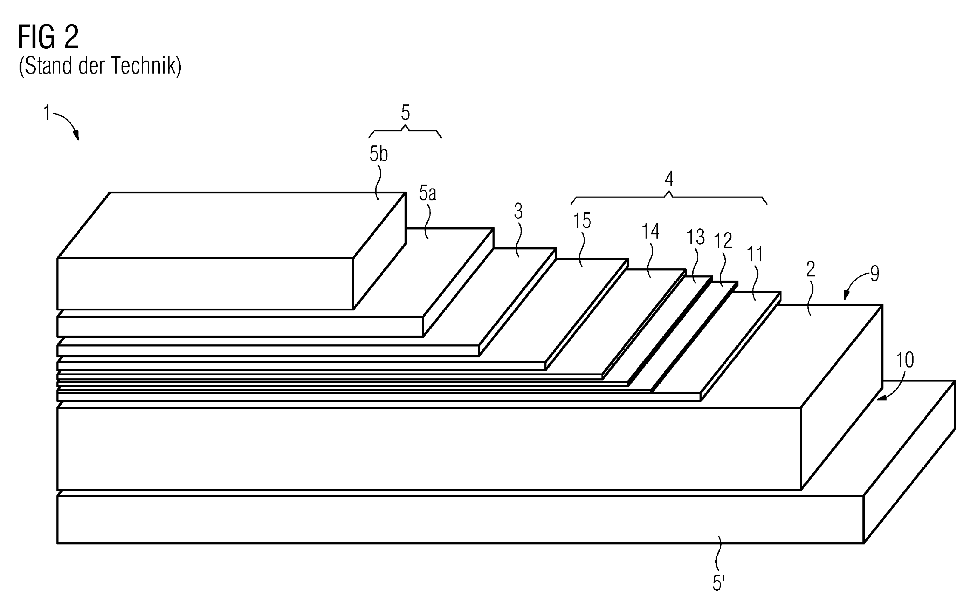

In Fig. 2 ist der Schichtaufbau eines Filaments 20 nach dem Stand der Technik im Detail dargestellt. Auf der Vorderseite 9 des Substrates 2 ist eine dünne Aluminium (Al)-Schicht 11 als Streifen aufgebracht, wobei in Fig. 2 eine Schrägansicht einer Schnittdarstellung längs des Streifens zu sehen ist. Auf der Al-Schicht 11 ist eine Schicht Yttria 12. Darauf ist eine Schicht IBAD Magnesium-Oxid (MgO) 13 und eine epitaktische Homo-epi MgO Schicht 14 abgeschieden. Auf der epitaktischen Homo-epi Mgo Schicht 14 ist eine epitaktische LMO Schicht 15 ausgebildet. Diese Schichten 11 bis 15 bilden zusammen die Pufferschicht 4 und wirken elektrisch isolierend gegenüber dem Substrat 2. Sie dienen als einkristallin geordnete Unterlage und führen zu einem einkristallinen Aufwachsen der supraleitenden Schicht 3, z.B. aus YBCO, auf dem Substrat 2 über der Pufferschicht 3.

Auf der supraleitenden Schicht 3 ist eine Silber (Ag)-Schicht 5a und eine Kupfer (Cu)-Schicht 5b ausgebildet. Diese beiden Schichten bilden die Stabilisierungsschicht 5, welche die supraleitenden Schicht 3 vor mechanischen Beschädigungen Schützt und Fehlstellen im einkristallinen supraleitenden Material elektrisch überbrückt.

Auf der Rückseite 10 des Substrats 2 kann eine weitere Cu-Schicht als zweite Stabilisierungsschicht 5' ausgebildet sein.

Das Substrat 2 des Multifilamentleiters 1 in den Figuren 1 und 2 besteht aus Hastelloy oder Stahl, ist $50\mu m$ Dick und weist eine Breite von 10mm auf. Das in Fig. 2 dargestellte Filament 20 weist eine Pufferschicht 3 mit einer Dicke von 100nm auf, und hat eine Breite von 0,5mm. Die supraleitende Schicht 3 ist $1\mu m$ dick und die Stabilisierungsschicht 5 auf der Vorderseite 9 des Substrats 2 ist $23\mu m$ dick ausgebildet, mit einer $20\mu m$ dicken Cu-Schicht. Die Stabilisierungsschicht 5' auf der Rückseite 10 des Substrats 2 aus Kupfer ist 20μm dick.

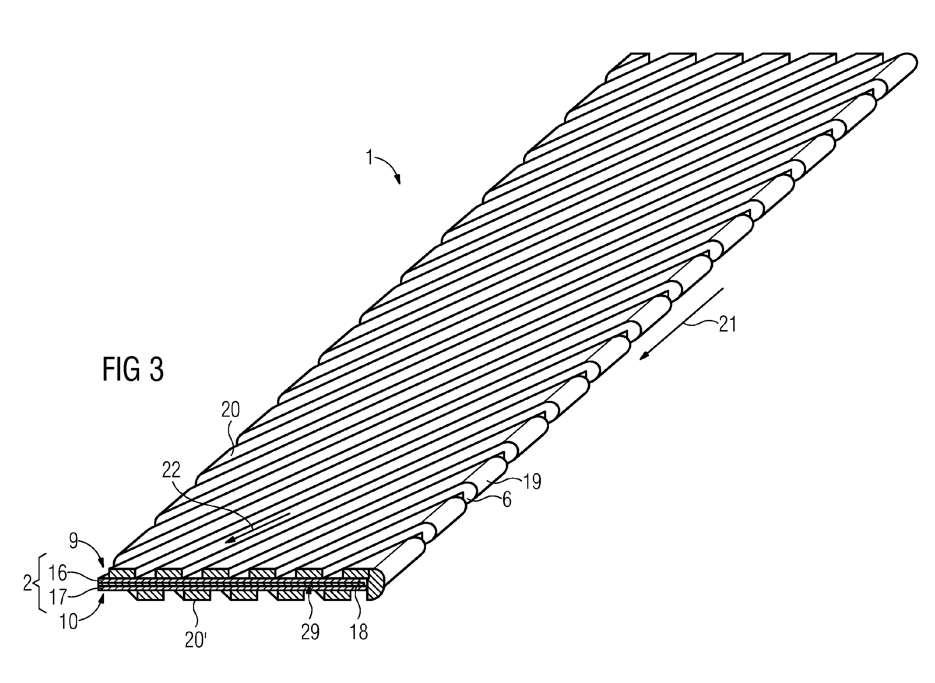

In Fig. 3 ist ein erfindungsgemäßer Multifilamentleiter 1 in Schrägansicht von oben dargestellt. Das Substrat 2 des Multifilamentleiters 1 besteht aus Hastelloy oder Stahl, ist 50 μm Dick und weist eine Breite von 10mm auf. Die Filamente 20, 20' sind in diesem Ausführungsbeispiel mit einer zweiten Richtung 22, welche die Längsrichtung der Filamente 20 darstellt, auf dem Substrat 2 angeordnet, welche mit der ersten, der Längsrichtung 21 des Substrats 2, einen Winkel zwischen 1 und 5 Grad einschließt. Die supraleitenden Filamente 20, 20' sind jeweils auf einer Oberfläche eines ersten und zweiten Trägers 16 und 17 angeordnet. Die zwei Träger 16 und 17 sind auf ihren Rückseiten, welche den Oberflächen mit Filamenten 20, 20' gegenüber liegen, beide miteinander in mechanischer Verbindung, aber elektrisch durch eine Zwischenschicht 29 im Wesentlichen getrennt, wobei die sich berührenden Rückseiten im Weiteren als Seite der mechanischen Verbindung 18 bezeichnet werden. Die zwei Träger 16 und 17 und die Zwischenschicht 29 bilden zusammen das bandförmige Substrat 2 des erfindungsgemäßen Multifilamentleiters 1.

Zwischen den Filamenten 20, 20' auf einer Oberfläche des Substrats 2 sind jeweils Gräben 6 durchgehend ausgebildet, so dass die supraleitende Schicht 3 zweier benachbarter Filamente 20, 20' jeweils elektrisch voneinander getrennt ist. Die Filamente 20 auf dem ersten Träger 16 sind jeweils so angeordnet, dass sie am Rand 19 des Trägers 16 mit den Filamenten 20' des zweiten Trägers 17 am Rand 19 des Trägers 16, 17 deckungsgleich übereinander liegen. Bei der Abscheidung oder Ausbildung der Stabilisierungsschicht 5 auf den Trägern 16 und 17 wird am Rand 19 das Material der Stabilisierungsschicht 5 mit abgeschieden. Dadurch werden über dieses Material die Filamente 20 des Trägers 16 mit den Filamenten 20' des Trägers 17 elektrisch verbunden. Bei der Ausbildung der Gräben 6, werden diese ebenfalls durch das Material der Stabilisierungsschicht 5 am Rand 19 vollständig durchgehend ausgebildet, so dass nur am Rand 19 übereinander liegende Filamente 20 und 20' elektrisch miteinander verbunden sind.

Die Schichtdicken und Substrat- 2 sowie Filament- 20, 20' Breiten sind gleich der zuvor für den Multifilamentleiter 1 der Figuren 1 und 2 beschriebenen Dicken und Breiten.

Der Winkel der Filamente 20 auf der Vorderseite 9 weist den entgegen gesetzten Wert des Winkels der Filamente 20' auf der Rückseite 10 auf. Der Wert des Winkels liegt im Bereich von 1 bis 5 Grad bzw. von - 1 bis - 5 Grad. Es sind auf der Vorder- und Rückseite 9, 10 supraleitende Filamente 20, 20' mit begrenzter Länge b gebildet, welche an den Rändern 19 des bandförmigen Substrats 2 enden. Auf die supraleitenden Filamente 20, 20' ist eine Stabilisierungsschicht 5, 5' aus normalleitendem Material aufgebracht, z.B. aus Kupfer, welche mit der supraleitenden Schicht 3 der Filamente 20, 20' in elektrischer Verbindung steht und den Strom an einer defekten normalleitenden Stelle des Supraleiters überbrücken kann. An den Rändern 19 des bandförmigen Substrats 2 ist die Stabilisierungsschicht 5, 5'so ausgebildet, dass die Filamente 20, 20' der Vorder- und Rückseite 9, 10 über eine normalleitende Schicht elektrisch verbunden sind.

Dadurch bilden sich um das bandförmige Substrat 2 ein oder mehrere spiralförmige, parallele Strompfade, welche supraleitend sind bis auf kurze, normalleitende Bereiche an den Rändern 19 des bandförmigen Substrats 2. Damit ist erfindungsgemäß ein Dünnschichtsupraleiter mit einem aus der klassischen Supraleitertechnik bekannten "Twist" in Form paralleler, verdrillter Supraleiter-Filamente erzeugt, der in Wechselfeldanwendungen geringe Verluste aufweist.

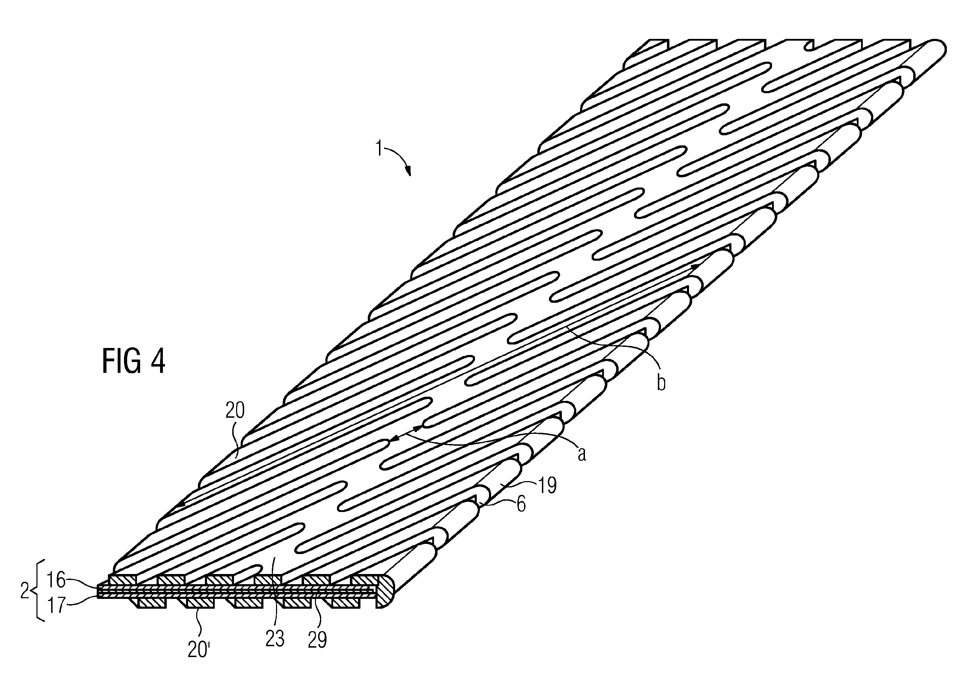

In Fig. 4 ist ein alternatives Ausführungsbeispiel des erfindungsgemäßen Multifilamentleiters 1 dargestellt. Dieser Multifilamentleiter 1 ist anlog dem in Fig. 3 dargestellten Multifilamentleiter 1, mit Ausnahme der zusätzlichen Ausbildung von Brücken 23 zwischen benachbarten Filamenten 20, 20'. Die Brücken 23 sind vom Schichtaufbau her gleich den Filamenten 20, 20' der Fig. 1 bis 3 aufgebaut, oder bestehen nur aus der Stabilisierungsschicht 5 oder aus der Stabilisierungsschicht 5 und der supraleitenden Schicht 3. Sie sind elektrisch leitend ausgebildet und können Fehlstellen in der supraleitenden Schicht 3 eines Filaments 20, 20' über die supraleitende Schicht 3 des benachbarten Filaments 20, 20' überbrücken. In Fig. 4 sind die Brücken 23 als ein Steg mittig auf der Oberfläche des Substrats 2 längs seiner ersten Richtung 21 angeordnet. Alternativ können die Brücken 23 aber auch am oder nahe dem Rand 19 angeordnet sein. Sie können auch nicht als durchgehender Steg, sondern abwechselnd oder unregelmäßig auf der Oberfläche zwischen jeweils zwei benachbarten Filamenten 20, 20' angeordnet sein. Im Ausführungsbeispiel, welches in Fig. 4 dargestellt ist, beträgt die Breite a der Brücken 23 im Bereich von 1/20 der Länge b eines Filaments 20 oder 20' auf einer Seite des Substrates 2. Je nach Material und geforderter Stromtragfähigkeit kann die Breite der Brücken 23 auch andere Werte annehmen.

In Multifilamentleitern 1 steigt die Wahrscheinlichkeit, dass eine lokale Schwachstelle in einem Filament 20 bzw. 20' die Stromtragfähigkeit reduziert, mit größerer Länge und kleinerer Breite. In Wicklungen mit großer Länge des Multifilamentleiters 1 kann so die Stromtragfähigkeit des ganzen Multifilamentleiters 1 mit voneinander isolierten Filamenten 20 bzw. 20' erheblich beeinträchtigt sein. Durch die Anordnung von Brücken 23 zwischen Filamenten 20 bzw. 20' kann eine Umverteilung des Stroms aus einem schadhaften Filamente 20 bzw. 20' in Nachbarfilamente 20 bzw. 20' erfolgen. Sofern entlang der Filamente 20 bzw. 20' der mittlere Abstand zwischen Schwachstellen erheblich größer ist als die Transpositionslänge L, findet der Gesamtstrom genügend intakte Strompfade und der kritische Gesamtstrom ist auch in langen Multifilamentleitern 1 nur wenig reduziert.

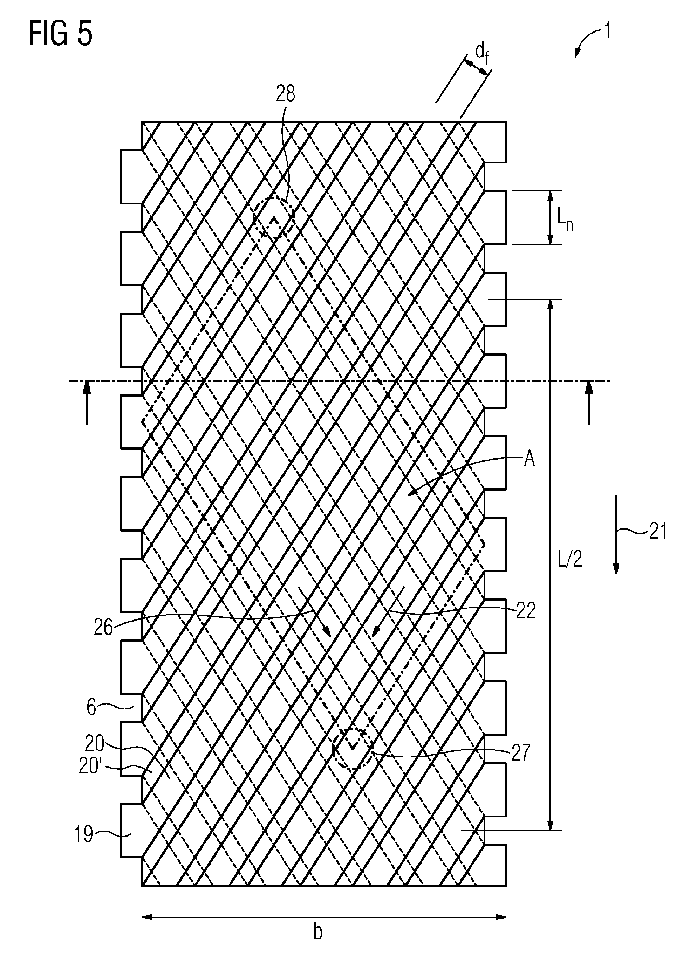

In Fig. 5 ist eine Aufsicht eines Multifilamentleiters 1 entsprechend der in Fig. 3 dargestellten Ausführungsform gezeigt. Es ist ersichtlich, dass die zweite Richtung 22 der Filamente 20 auf dem ersten Träger 16 (durchgezogene Linien als Begrenzung in der Breite der Filamente 20 in der Fig. 5) in einem Winkel zu einer dritten Richtung 26 der Längsausdehnung der Filamente 20' auf dem zweiten Träger 17 (gestrichelte Linien als Begrenzung in der Breite der Filamente 20'in der Fig. 5) angeordnet ist. Die Filamente 20 und 20' auf dem Träger 16 und 17 schließen somit einen Winkel ein. Der Winkel liegt im Bereich weniger Grad.

Über die elektrische Verbindung am Rand 19 bilden die Filamente 20, 20' auf dem ersten 16 und zweiten Träger 17 einen verdrillten bzw. transponierten Multifilamentleiter 1. Die Filamente 20, 20' umlaufen den Leiter spiralförmig. Für die Verluste $P_h$ durch eine zum Multifilamentleiter 1 senkrechte Wechselfeldamplitude $\Delta B$ ist nicht mehr die Leiterbreite b, wie es bei einem Leiter ohne Filamente 20, 20'der Fall ist, sondern die Breite $d_f$ der Einzelfilamente 20, 20' maßgebend. Der Anteil der Hystereseverluste verringert sich um den Faktor $d_f/b$. Durch die Transponierung der Filamente 20, 20' sind auch Verluste durch Abschirmströme, welche zwischen den Filamenten 20, 20' induziert werden, kleiner oder gleich Null, falls die Pufferschicht 4 zum Träger 16, 17 hin hinreichend isoliert ist. Der Magnetfluss durch die Fläche zwischen zwei beliebigen parallelen Filamenten 20 oder 20' summiert sich nach einem Umlauf nach einer Transpositionslänge L jeweils zu Null. Die dazwischen induzierten Spannungen, und damit die verlusterzeugenden Wirbelströme, werden so unabhängig von der gesamten Länge des Multifilamentleiters 1 wirksam verringert.

In Fig. 5 ist als Strich-Punkt-Linie beispielhaft eine Fläche A eingezeichnet, welche von zwei beliebigen Filamenten 20 an der Vorderseite9 oder 20'an der Rückseite 10 eingeschlossen wird. Die Fläche A wird bei einer zur Fläche A senkrechten Feldkomponente B von einem Magnetfluss BxA durchsetzt. Über jeden der zwei Kreuzungspunkte 27, 28 der Filamente 20, 20'der Vorder- 9 und Rückseite 10 des Substrats 2 steht eine induzierte Spannung U = ½ A dB/dt an. Sie ist in der Leitermitte am höchsten und am Rand 19 Null. Eine erfindungsgemäße elektrisch isolierende Schicht 29 zwischen dem ersten und zweiten Träger 16 und 17 verhindert induzierte Ströme senkrecht durch das dünne Substrat 2 zwischen Filamenten 20 und 20'. Diese Ströme würden sich dem Transportstrom in den Filamenten 20, 20'überlagern und die Filamente 20, 20'in den resistiven, verlustbehafteten Bereich treiben sowie zusätzlich ohmsche Verluste in dem Substrat 2 erzeugen. Mit der elektrisch isolierende Schicht 29 bzw. Zwischenschicht zwischen dem ersten Träger 16 und dem zweiten Träger 17, wird eine magnetische Kopplung über das Substrat 2 verhindert.

In Magnetanwendungen, in welchen eine hohe Feldgenauigkeit gefordert wird, wie dies z.B. in Kernspintomographen, Beschleunigern und Kernresonanzspektrometern der Fall ist, werden durch die kleineren und auf die Filamentbreite lokalisierten Abschirmströme die dadurch erzeugten Feldfehler im Nutzvolumen erheblich reduziert. Somit kann der erfindungsgemäße Multifilamentleiter 1 auch in kritischen Gleichstromanwendungen verwendet werden.

Bei normalleitenden elektrischen Kontakten zwischen den Filamenten 20 und 20' über die Ränder 19 besteht ein ohmscher Widerstand $R_n$, welcher näherungsweise

$$R_n = \rho_n \, \pi \, (d_n + d_s) \, / \, (d_n \, L_n)$$

beträgt, wobei $\rho_n$ der spezifische elektrische Widerstand ist, $d_n$, $d_s$ die Dicken der Normalmetallschicht und des Trägers 16, 17 sind, $L_n = d_f L / 2 b$ die Länge einer Brücke 23 in erster Richtung 21 ist, und $d_f$ die Filamentbreite ist. Zwei Brücken 23 pro Verseillänge L summieren sich in jedem Filament 20, 20' zu einen mittleren Widerstand pro Länge von

$$\langle R_n \rangle \, / \, l = \rho_n \, \pi \, (d_n + d_s) \, 2 \, b \, / \, (d_n \, d_f \, L^2).$$

Mit großer Transpositionslänge L kann dieser Widerstand sehr klein werden. So ist z.B. für einen Multifilamentleiter 1 mit b = 10mm Breite, 0,3mm Gesamtdicke, $I_C$ = 300A, 15 Filamenten 20, 20' der Breite $d_f$ = 0,5mm, einer effektiven kritischen Stromdichte im Multifilamentleiter 1 von $j_e$ = 100A/mm$^2$, einer Transpositions- bzw. Versaillänge von L = 20cm, $\rho_n$ = 2x10$^{-9}$ $\Omega$m in Kupfer bei 77K, und einer Dicke von Kupferschicht 5 und Substrat 2 von $d_n$ = $d_s$ = 0,1mm der gemittelte ohmsche Widerstand eines Filaments 20, 20' durch eine Kupferbrücke 23 durch

$$\langle R_n \rangle \, / \, l = 12{,}5 \, \mu\text{Ohm/m}$$

gegeben.

Bei I = $I_C$/15 = 20A im Filament 20, 20' ist der Spannungsabfall 250$\mu$V/m bzw. 2,5 $\mu$V/cm. Dies ist im Bereich des Spannungsabfalls 1$\mu$V/cm, bei dem üblicherweise der kritische Strom in technischen Supraleitern definiert wird.

Zusatzverluste wachsen quadratisch mit dem Strom. Bei $I_C$ = 300A sind dies 75mW pro Meter Multifilamentleiter 1 oder 250 mW pro Kilo-Amperemeter. Verglichen mit konventionellen Lösungen ergibt ein Multifilamentleiter 1 gemäß der Erfindung mit HTS-Material somit eine Energieeinsparung von 90% verglichen mit ohmschen Leitern aus Kupfer. Magnetisierungsverluste $P_h$ im supraleitenden Material lassen sich, wie schon beschrieben, durch kleine Filamentbreiten

$d_f$ reduzieren. Somit sind Wechselstromanwendungen bei 50/60 Hertz in supraleitenden Kabeln, supraleitenden Trafos, elektrischen Maschinen mit Supraleitern und anderen Anwendungen mit den erfindungsgemäßen Multifilamentleitern 1 wirtschaftlich zu realisieren. Hinzu kommen als Vorteil gegenüber herkömmlichen Kupferleitern die um ein bis zwei Größenordnungen höheren Stromdichten, welche möglich sind.

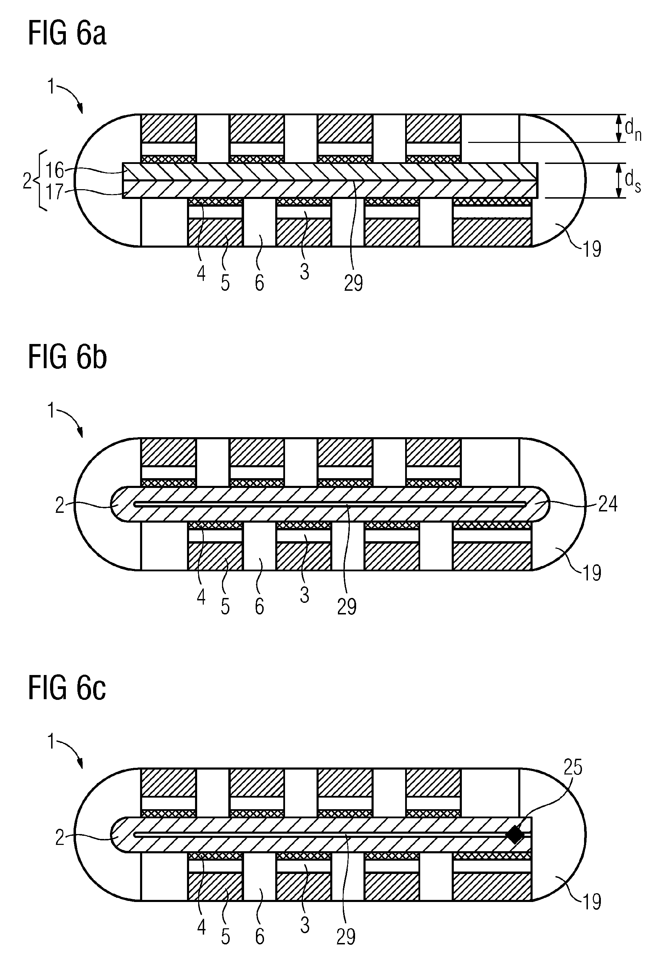

In den Fig. 6a bis 6c sind Schnittdarstellungen des in Fig. 5 dargestellten Multifilamentleiters 1 mit unterschiedlichen Ausführungsformen der Verbindung 18 über wenigstens eine Zwischenschicht 29 des ersten und zweiten Trägers 16 und 17 gezeigt. Die Filamente 20, 20' sind gleich den zuvor beschriebenen Filamenten 20, 20' aus einem Schichtstapel Pufferschicht 4, supraleitende Schicht 3 und Stabilisierungsschicht 5 aufgebaut. Zwischen benachbarten Filamenten 20, 20' sind jeweils Gräben 6 ausgebildet. Filamente 20, 20' auf der Vorder- 9 und Rückseite 10 des Substrats 2 sind über den Rand 19 durch die Stabilisierungsschicht 5 miteinander elektrisch verbunden.

In Fig. 6a sind der erste Träger 16 und der zweite Träger 17 jeweils miteinander flächig, elektrisch isolierend über ihre Rückseite verbunden. Die Verbindung kann z.B. durch Kleben der Rückseiten aufeinander erfolgen. Zwischen der Trägern 16 und 17 kann zusätzlich eine wärmeisolierende Schicht angeordnet sein.

In Fig. 6b sind die Träger 16 und 17 dadurch ausgebildet, dass ein Rohr 24 aus Substratmaterial 2 zusammengepresst wird. Ein dünner isolierender Luftspalt kann im Inneren des Rohres bestehen bleiben, welcher auch zur Kühlung genutzt werden kann. So kann z.B. flüssiger Stickstoff durch diesen Spalt geleitet werden und den Multifilamentleiter 1 von innen her zusätzlich kühlen.

In Fig. 6c sind der erste und der zweite Träger 16 und 17 durch Zusammenfalten eines breiten Trägers ausgebildet, mit einer Breite des breiten Trägers gleich der doppelten Breite eines Trägers 16, 17, wobei die Faltlinie in der Mitte des breiten Trägers entlang seiner Längsachse verläuft. Die Faltlinie bildet einen Rand 19 des Substrats 2, und entlang des gegenüberliegenden Rands 19 des Substrats 2 kann eine Schweiß- oder Klebenaht 25 den ersten und zweiten Träger 16 und 17 mechanisch stabil miteinander verbinden. Bei Abscheidung der Stabilisierungsschicht 5 und Ausbildung der Gräben 6 werden über die Ränder 19 jeweils die Filamente 20 des ersten und zweiten Trägers 16 und 17 verbunden, wobei bei Ausbildung der Gräben 6 auch am Rand 19 benachbarte Filamente 20 eines Trägers 16 oder 17 jeweils elektrisch voneinander am Rand 19 getrennt sind. Eine Kombination der Ausführungsbeispiele in den Fig. 6a bis 6c mit dem Ausführungsbeispiel aus Fig. 4 ergibt über die Brücken 23 eine elektrische Verbindung von Filamenten 20 auf einem Träger 16 oder 17.

## Patentansprüche

1. Multifilamentleiter (1) mit einem bandförmigen Substrat (2) und mit wenigstens einer supraleitenden Schicht (3), wobei die wenigstens eine supraleitende Schicht (3) auf wenigstens einer Oberfläche des bandförmigen Substrats (2) ausgebildet ist und in Filamente (20, 20') unterteilt ist, und wobei das bandförmige Substrat (2) parallel zu seiner Längsausdehnung eine erste Richtung (21) aufweist und wenigstens ein Filament (20, 20') parallel zu seiner Längsausdehnung eine zweite Richtung (22) aufweist, **dadurch gekennzeichnet, dass** die erste Richtung (21) des bandförmigen Substrats (2) mit der zweiten Richtung (22) des wenigstens einen Filaments (20, 20') einen Winkel eirischließt, **dadurch gekennzeichnet, dass** dieser Winkel zwischen 1 und 5 Grad liegt.

2. Multifilamentleiter (1) nach Anspruch 1, **dadurch gekennzeichnet, dass** das wenigstens eine Filament (20, 20') vollständig entlang der zweiten Richtung (22) ausgebildet ist, insbesondere ohne eine Längskomponente parallel der ersten Richtung (21).

3. Multifilamentleiter (1) nach einem der vorhergehenden Ansprüche, **dadurch gekennzeichnet, dass** das bandförmige Substrat (2) eine erste Oberfläche auf einer Vorderseite (9) und eine gegenüberliegende zweite Oberfläche auf einer Rückseite (10) aufweist, und sowohl auf der ersten als auch auf der zweiten Oberfläche mehrere Filamente (20, 20') ausgebildet sind, wobei insbesondere die Filamente (20) der ersten Oberfläche eine zweite Richtung (22) aufweisen, welche ungleich einer dritten Richtung (23) parallel der Längsrichtung der Filamente (20') der zweiten Oberfläche ist.

4. Multifilamentleiter (1) nach Anspruch 3, **dadurch gekennzeichnet, dass** wenigstens ein Filament (20) der Vorderseite (9) mit wenigstens einem Filament (20') der Rückseite (10) elektrisch leitend verbunden ist, insbesondere über wenigstens eine Schicht (19), welche auf wenigstens einer dritten Oberfläche auf einer oder zwei Seitenflächen des bandförmigen Substrats (2) ausgebildet ist.

5. Multifilamentleiter (1) nach einem der vorhergehenden Ansprüche, **dadurch gekennzeichnet, dass** zwischen wenigstens zwei benachbarten Filamenten (20, 20') auf einer Oberfläche wenigstens eine elektrische Brücke (23) ausgebildet ist, durch welche eine elektrische Verbindung der wenigstens zwei benachbarten Filamente (20, 20') gebildet ist.

6. Multifilamentleiter (1) nach Anspruch 5, **dadurch gekennzeichnet, dass** die wenigstens eine elektrische Brücke (23) mittig auf der einen Oberfläche angeordnet ist, insbesondere mit einer Längsrichtung der Brücke (23) parallel der einen ersten Richtung (21) des bandförmigen Substrats (2).

7. Multifilamentleiter (1) nach einem der vorhergehenden Ansprüche, **dadurch gekennzeichnet, dass** der Multifilamentleiter (1) einen Schichtstapel aus bandförmigen Trägermaterial (16, 17), wenigstens eine Pufferschicht (4), wenigstens eine supraleitende Schicht (3), insbesondere eine Hochtemperatur-Supraleitende (HTS)-Schicht, und/oder wenigstens eine Stabilisierungsschicht (5) aufweist.

8. Multifilamentleiter (1) nach Anspruch 7, **dadurch gekennzeichnet, dass** das Trägermaterial (16, 17) aus einem Metall, insbesondere Stahl besteht, und/oder die wenigstens eine Pufferschicht (4) wenigstens ein Material aus der Gruppe Al (11), Yttria (12), IBAD MgO (13), Homo-epi MgO (14), LMO (15), umfasst oder Kombinationen und/oder Schichtstapel aus diesen Materialien, und/oder die wenigstens eine supraleitende Schicht (3) aus YBCO besteht, und/oder die wenigstens eine Brücke (23) aus YBCO besteht, insbesondere aus YBCO der wenigstens einen HTS-Schicht, und/oder die wenigstens eine Stabilisierungsschicht (5) aus Kupfer oder Silber besteht oder einen Schichtstapel mit wenigstens einer Kupfer- (5b) und/oder wenigstens einer Silbeschicht (5a) umfasst, und/oder die wenigstens eine Brücke (23) aus dem Material der wenigstens eine Stabilisierungsschicht (5) besteht oder dieses umfasst.

9. Multifilamentleiter (1) nach Anspruch 7 oder 8, **dadurch gekennzeichnet, dass** das Trägermaterial (16, 17) eine Dicke im Bereich von 50 bis 100$\mu$m und eine Breite im Bereich von 10mm aufweist, und/oder die wenigstens eine Pufferschicht (4) eine Dicke im Bereich von 100nm aufweist, und/oder die wenigstens eine supraleitende Schicht (3) eine Dicke im Bereich von 1$\mu$m aufweist, und/oder das wenigstens eine Filament (20, 20') eine Breite im Bereich von 0.5mm aufweist, und/oder die wenigstens eine Stabilisierungsschicht (5) eine Dicke im Bereich von 3$\mu$m aufweist.

10. Multifilamentleiter (1) nach einem der vorhergehenden Ansprüche, **dadurch gekennzeichnet, dass** die Filamente (20, 20') transponiert sind, insbesondere mit einer Transpositionslänge im Bereich von 20cm.

11. Verfahren zur Herstellung eines Multifilamentleiters (1) nach einem der vorhergehenden Ansprüche, **dadurch gekennzeichnet, dass** zwei bandförmige Trägermaterialien (16, 17) mit sich gegenüberliegenden Seiten in mechanischer Verbindung miteinander gebracht werden, insbesondere deckungsgleich, wobei jeweils auf einer Seite eines bandförmigen Trägermaterials (16, 17), welche der Seite der mechanischen Verbindung (18) gegenüber liegt, wenigstens eine supraleitende Schicht (3) aufgebracht wird und auf die supraleitende Schicht (3) eine Stabilisierungsschicht (5) aufgebracht wird, wobei die Stabilisierungsschicht (5) eines ersten bandförmigen Trägermaterials (16) mit der Stabilisierungsschicht (5') eines zweiten bandförmigen Trägermaterials (17) an den Rändern (19) der zwei bandförmigen Trägermaterialien (16, 17) überlappend ausgebildet werden, so dass eine elektrische Verbindung der Stabilisierungsschichten (5, 5') über die Ränder (19) erfolgt, und die supraleitenden Schichten (3) und die Stabilisierungsschichten (5, 5') in Filamente (20, 20') unterteilt werden.

12. Verfahren nach Anspruch 11, **dadurch gekennzeichnet, dass** das Aufbringen von Schichten durch Elektrolyse, Auflöten, Aufdampfen, Sputtern, und/oder thermische Zersetzung von Metallverbindungen in der Dampfphase erfolgt, und/oder die Unterteilung der supraleitenden Schichten (3) und die Unterteilung der Stabilisierungsschichten (5, 5') in Filamente (20, 20') durch Lasern und/oder Ätzen, insbesondere chemisches Ätzen, von durch eine Schicht jeweils durchgehenden Gräben (6) erfolgt.

13. Verfahren nach Anspruch 12, **dadurch gekennzeichnet, dass** die Gräben (6) in einem Winkel zwischen der ersten Richtung (21) des bandförmigen Substrats (2) und der zweiten Richtung (22) des wenigstens einen Filaments (20, 20') zwischen 1 und 5 Grad ausgebildet werden und die Filamente (20, 20') auf den zwei bandförmigen Trägermaterialien (16, 17) über deren Ränder (19) elektrisch derart verbunden werden, dass spiralförmige Strompfade entstehen.

14. Verfahren nach Anspruch 11, **dadurch gekennzeichnet, dass** das Aufbringen von Schichten durch Bedrucken, Bekleben, Elektrolyse, Auflöten, Aufdampfen, Sputtern und/oder thermische Zersetzung von Metallverbindungen in der Dampfphase erfolgt, wobei eine Filamentstruktur (20, 20') direkt ausgebildet wird.

15. Verfahren nach einem der Ansprüche 11 bis 14, **dadurch gekennzeichnet, dass** die zwei bandförmigen Trägermaterialien (16, 17) durch eine hitzebeständige, isolierende Zwischenlage 29 und/oder einen Luftspalt voneinander getrennt werden, insbesondere durch verschweißen (25) der zwei bandförmigen Trägermaterialien (16, 17), durch Biegen eines bandförmigen Trägerbandes in zwei übereinanderliegende Bänder (16, 17), oder durch Flachwalzen eines Rohres (24), insbesondere vor einem Schritt des texturierenden Walzens der bandförmigen Trägermaterialien (16, 17).

**Claims**

1. Multifilament conductor (1) comprising a ribbon-shaped substrate (2) and at least one superconducting layer (3), wherein the at least one superconducting layer (3) is formed on at least one surface of the ribbon-shaped substrate (2) and is subdivided into filaments (20, 20'), and wherein the ribbon-shaped substrate (2) has a first direction (21) parallel to its longitudinal extent and the at least one filament (20, 20') has a second direction (22) parallel to its longitudinal extent, **characterized in that** the first direction (21) of the ribbon-shaped substrate (2) makes an angle with the second direction (22) of the at least one filament (20, 20'), **characterized in that** this angle lies between 1 and 5 degrees.

2. Multifilament conductor (1) according to Claim 1, **characterized in that** the at least one filament (20, 20') is formed fully along the second direction (22), in particular without a length component parallel to the first direction (21).

3. Multifilament conductor (1) according to one of the preceding claims, **characterized in that** the ribbon-shaped substrate (2) has a first surface on a front side (9) and an opposite second surface on a rear side (10), and a plurality of filaments (20, 20') are formed on both the first and second surfaces, the filaments (20) of the first surface having in particular a second direction (22) which is not equal to a third direction (23) parallel to the longitudinal direction of the filaments (20') of the second surface.

4. Multifilament conductor (1) according to Claim 3, **characterized in that** at least one filament (20) of the front side (9) is electrically conductively connected to at least one filament (20') of the rear side (10), in particular by means of at least one layer (19) which is formed on at least one third surface on one or two side faces of the ribbon-shaped substrate (2).

5. Multifilament conductor (1) according to one of the preceding claims, **characterized in that** between at least two neighboring filaments (20, 20') on one surface, at least one electrical bridge (23) is formed by which an electrical connection of the at least two neighboring filaments (20, 20') is formed.

6. Multifilament conductor (1) according to Claim 5, **characterized in that** the at least one electrical bridge (23) is arranged centrally on the one surface, in particular with a longitudinal direction of the bridge (23) parallel to the one first direction (21) of the ribbon-shaped substrate (2).

7. Multifilament conductor (1) according to one of the preceding claims, **characterized in that** the multifilament conductor (1) comprises a layer stack consisting of ribbon-shaped carrier material (16, 17), at least one buffer layer (4), at least one superconducting layer (3), in particular a high-temperature superconducting (HTS) layer, and/or at least one stabilization layer (5).

8. Multifilament conductor (1) according to Claim 7, **characterized in that** the carrier material (16, 17) consists of a metal, in particular steel, and/or the at least one buffer layer (4) comprises at least one material from the group: Al (11), yttria (12), IBAD MgO (30), homo-epi MgO (14), LMO (15), or combinations and/or layer stacks of these materials, and/or the at least one superconducting layer (3) consists of YBCO, and/or the at least one bridge (23) consists of YBCO, in particular the YBCO of the at least one HTS layer, and/or the at least one stabilization layer (5) consists of copper or silver or comprises a layer stack with at least one copper (5b) and/or at least one silver layer (5a), and/or the at least one bridge (23) consists of or comprises the material of the at least one stabilization layer (5).

9. Multifilament conductor (1) according to Claim 7 or 8, **characterized in that** the carrier material (16, 17) has a thickness in the range of from 50 to 100 $\mu$m and a width in the region of 10 mm, and/or the at least one buffer layer (4) has a thickness in the region of 100 nm, and/or the at least one superconducting layer (3) has a thickness in the region of 1 $\mu$m, and/or the at least one filament (20, 20') has a width in the region of 0.5 mm, and/or the at least one stabilization layer (5) has a thickness in the region of 3 $\mu$m.

**10.** Multifilament conductor (1) according to one of the preceding claims, **characterized in that** the filaments (20, 20') are transposed, in particular with a transposition length in the region of 20 cm.

**11.** Method for producing a multifilament conductor (1) according to one of the preceding claims, **characterized in that** two ribbon-shaped carrier materials (16, 17) are brought into mechanical connection with one another via opposite sides, in particular congruently, with at least one superconducting layer (3) respectively being applied on a side of a ribbon-shaped carrier material (16, 17) which lies opposite the side of the mechanical connection (18) and a stabilization layer (5) being applied onto the superconducting layer (3), the stabilization layer (5) of a first ribbon-shaped carrier material (16) being formed overlapping with the stabilization layer (5') of a second ribbon-shaped carrier material (17) at the edges (19) of the two ribbon-shaped carrier materials (16, 17) so that an electrical connection of the stabilization layers (5, 5') is established via the edges (19), and the superconducting layers (3) and the stabilization layers (5, 5') being subdivided into filaments (20, 20').

**12.** Method according to Claim 11, **characterized in that** the application of layers is carried out by electrolysis, soldering, evaporation coating, sputtering and/or thermal decomposition of metal compounds in the vapor phase, and/or the subdivision of the superconducting layers (3) and the subdivision of the stabilization layers (5, 5') into filaments (20, 20') is carried out by lasering and/or etching, in particular chemical etching, of trenches (6) respectively passing fully through a layer.

**13.** Method according to Claim 12, **characterized in that** the trenches (6) are formed with an angle of between 1 and 5 degrees between the first direction (21) of the ribbon-shaped substrate (2) and the second direction (22) of the at least one filament (20, 20'), and the filaments (20, 20') on the two ribbon-shaped carrier materials (16, 17) are electrically connected via their edges (19) so as to form spiral-shaped current paths.

**14.** Method according to Claim 11, **characterized in that** the application of layers is carried out by printing, adhesive bonding, electrolysis, soldering, evaporation coating, sputtering and/or thermal decomposition of metal compounds in the vapor phase, with a filament structure (20, 20') being formed directly.

**15.** Method according to one of Claims 11 to 14, **characterized in that** the two ribbon-shaped carrier materials (16, 17) are separated from one another by a heat-resistant insulating interlayer (29) and/or an air gap, in particular by welding (25) the two ribbon-shaped carrier materials (16, 17), by folding a ribbon-shaped carrier ribbon into two ribbons (16, 17) lying above one another, or by rolling a tube (24) flat, in particular before a step of texturizing rolling of the ribbon-shaped carrier materials (16, 17).

**Revendications**

**1.** Conducteur ( 1 ) multifilamentaire, ayant un substrat ( 2 ) en forme de bande et au moins une couche ( 3 ) supraconductrice, la au moins une couche ( 3 ) supraconductrice étant constituée sur au moins une surface du substrat ( 2 ) en forme de bande et étant subdivisée en des filaments ( 20, 20' ) et le substrat ( 2 ) en forme de bande ayant une première direction ( 21 ) parallèlement à son étendue longitudinale et au moins un filament ( 20, 20' ) ayant une deuxième direction ( 22 ) parallèlement à son étendue longitudinale, **caractérisé en ce que** la première direction ( 21 ) du substrat ( 2 ) en forme de bande fait, avec la deuxième direction ( 22 ) du au moins un filament ( 20, 20' ), un angle **caractérisé en ce que** cet angle est compris entre 1 et 5 degrés.

**2.** Conducteur ( 1 ) multifilamentaire suivant la revendication 1, **caractérisé en ce qu'**au moins un filament ( 20, 20' ) est constitué entièrement dans la deuxième direction ( 22 ), notamment sans un composant longitudinal parallèlement à la première direction ( 21 ).

**3.** Conducteur ( 1 ) multifilamentaire suivant l'une des revendications précédentes, **caractérisé en ce que** le substrat ( 2 ) en forme de bande a une première surface, sur une face ( 9 ) avant, et une deuxième surface opposée, sur une face ( 10 ) arrière, et plusieurs filaments ( 20, 20' ) sont constitués à la fois sur la première et sur la deuxième surfaces, notamment les filaments ( 20 ) de la première surface ayant une deuxième direction ( 22 ) qui n'est pas la même qu'une troisième direction ( 23 ) parallèlement à la direction longitudinale des filaments ( 20' ) de la deuxième surface.

**4.** Conducteur ( 1 ) multifilamentaire suivant la revendication 3, **caractérisé en ce qu'**au moins un filament ( 20 ) de la face ( 9 ) avant est relié d'une manière conductrice de l'électricité à au moins un filament ( 20' ) de la face ( 10 ) arrière, notamment par au moins une couche ( 19 ) qui est constituée sur au moins une troisième surface sur une ou deux faces latérales du substrat ( 2 ) en forme de bande.

5. Conducteur ( 1 ) multifilamentaire suivant l'une des revendications précédentes, **caractérisé en ce qu'**il est constitué entre au moins deux filaments ( 20, 20' ) voisins sur une surface au moins un pont ( 23 ) électrique par lequel une liaison électrique est formée entre les au moins deux filaments ( 20, 20' ) voisins.

6. Conducteur ( 1 ) multifilamentaire suivant la revendication 5, **caractérisé en ce que** le au moins un pont ( 23 ) électrique est disposé au milieu sur l'une des surfaces, en ayant notamment une direction longitudinale du pont ( 23 ) parallèlement à la première direction ( 21 ) du substrat ( 2 ) en forme de bande.

7. Conducteur ( 1 ) multifilamentaire suivant l'une des revendications précédentes, **caractérisé en ce que** le conducteur ( 1 ) multifilamentaire a un empilement de couches en un matériau ( 16, 17 ) support en forme de bande, au moins une couche ( 4 ) tampon, au moins une couche ( 3 ) supraconductrice, notamment une couche supraconductrice à haute température ( HTS ) et au moins une couche ( 5 ) de stabilisation.

8. Conducteur ( 1 ) multifilamentaire suivant la revendication 7, **caractérisé en ce que** le matériau ( 16, 17 ) support est en métal, notamment en acier et/ou la au moins une couche ( 4 ) tampon comprend au moins un matériau choisi dans le groupe Al ( 11 ), oxyde d'yttrium ( 12 ), IBAD MgO ( 13 ), homo-epi MgO ( 14 ), LMO ( 15 ) ou des combinaisons et/ou des empilements de couches en ces matériaux et/ou la au moins une couche ( 3 ) supraconductrice étant en YBCO, et/ou le au moins un pont ( 23 ) étant en YBCO, notamment en YBCO de la au moins une couche HTS et/ou la au moins une couche (5) de stabilisation est en cuivre ou en argent ou est un empilement de couches ayant au moins une couche de cuivre ( 5b ) et/ou au moins une couche ( 5a ) d'argent et/ou le au moins un pont ( 23 ) est en le matériau de la au moins une couche ( 5 ) de stabilisation ou en comprend.

9. Conducteur ( 1 ) multifilamentaire suivant la revendication 7 ou 8, **caractérisé en ce que** le matériau ( 16, 17 ) support a une épaisseur de l'ordre de 50 à 100 $\mu$m et une largeur de l'ordre de 10 mm et/ou la au moins une couche ( 4 ) tampon a une épaisseur de l'ordre de 100 nm et/ou la au moins une couche ( 3 ) supraconductrice a une épaisseur de l'ordre de 1 $\mu$m et/ou le au moins un filament ( 20, 20' ) a une largeur de l'ordre de 0,5 mm et/ou la au moins une couche ( 5 ) de stabilisation a une épaisseur de 3 $\mu$m.

10. Conducteur ( 1 ) multifilamentaire suivant l'une des revendications précédentes, **caractérisé en ce que** les filaments ( 20, 20' ) sont transposés, en ayant notamment une longueur de transposition de l'ordre de 20 cm.

11. Procédé de fabrication d'un conducteur ( 1 ) multifilamentaire suivant l'une des revendications précédentes, **caractérisé en ce qu'**on met en liaison mécanique entre eux, deux matériaux ( 16, 17 ) supports en forme de bande par des faces opposées, notamment en les faisant coïncider, au moins une couche ( 13 ) supraconductrice étant déposée, respectivement, sur une face d'un matériau ( 16, 17 ) support en forme de bande qui est opposée à la face de la liaison mécanique et une couche ( 5 ) de stabilisation étant déposée sur la couche ( 3 ) supraconductrice, la couche ( 5 ) de stabilisation d'un premier matériau ( 16 ) support en forme de bande étant disposée à chevauchement avec la couche ( 5' ) de stabilisation d'un deuxième matériau ( 17 ) support en forme de bande sur les bords ( 19 ) des deux matériaux ( 16, 17 ) supports en forme de bande de manière à produire une liaison électrique des couches ( 5, 5' ) de stabilisation par les bords ( 19 ) et les couches ( 3 ) supraconductrices et les couches ( 5, 5' ) de stabilisation sont subdivisées en des filaments ( 20, 20' ).

12. Procédé suivant la revendication 11, **caractérisé en ce que** le dépôt de couches s'effectue par électrolyse, par brasure, par dépôt en phase vapeur, par pulvérisation cathodique et/ou par décomposition thermique de composés métalliques en phase vapeur et/ou la subdivision des couches ( 3 ) supraconductrices et la subdivision des couches ( 5, 5' ) de stabilisation en des filaments ( 20, 20' ) s'effectuent en ménageant des sillons ( 6 ) traversant respectivement une couche par laser et/ou par attaque, notamment par attaque chimique.

13. Procédé suivant la revendication 12, **caractérisé en ce que** les sillons ( 6 ) sont constitués en faisant un angle entre la première direction ( 21 ) du substrat ( 2 ) en forme de bande et la deuxième direction ( 22 ) du au moins un filament ( 20, 20' ) compris entre 1 et 5 degrés et les filaments ( 20, 20' ) sur les deux matériaux ( 16, 17 ) supports en forme de bandes sont reliés électriquement par leurs bords ( 19 ) de manière à créer des trajets de courant en forme de spirale.

14. Procédé suivant la revendication 11, **caractérisé en ce que** le dépôt de couches s'effectue par impression, par collage, par électrolyse, par brasure, par dépôt en phase vapeur, par pulvérisation cathodique et/ou par décomposition thermique de composés métalliques en phase vapeur, la structure ( 20, 20' ) filamentaire étant constituée directement.

15. Procédé suivant l'une des revendications 11 à 14, **caractérisé en ce que** les deux matériaux ( 16, 17 ) supports en forme de bande sont séparés l'un de l'autre par une strate ( 29 ) intermédiaire isolante et résistante à la chaleur et/ou par un entrefer, notamment par soudage ( 25 ) des deux matériaux ( 16, 17 ) supports en forme de bande, par pliage d'une bande de support en forme de bande en deux bandes ( 16, 17 ) superposées ou par laminage à plat d'un tube ( 24 ), notamment avant un stade de laminage texturant des matériaux ( 16, 17 ) supports en forme de bande.

## FIG 1
(Stand der Technik)

EP 2 471 115 B1

FIG 2
(Stand der Technik)

EP 2 471 115 B1

FIG 3

FIG 4

1

b

a

19

6

20

29

23

20'

16
17

2

FIG 5

## FIG 6a

## FIG 6b

## FIG 6c

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 03100875 A2
- US 20070191202 A1
- US 20060040830 A1
- WO 01008169 A

**In der Beschreibung aufgeführte Nicht-Patentliteratur**

- *IEEE Transactions on Applied Superconductivity,* 2005, vol. 15, 2827-2830